# EUROPÄISCHE PATENTSCHRIFT

(11) **EP 2 109 220 B1**
(45) Veröffentlichungstag und Bekanntmachung des Hinweises auf die Patenterteilung: **10.04.2013**
(21) Anmeldenummer: 09002486.0
(22) Anmeldetag: 21.02.2009
(51) Int. Cl.: H03K 4/02, H03K 17/16

(54) **Verfahren und Treiberschaltung zur Ansteuerung eines Leistungshalbleiters**
Method and driver switch for controlling a voltage semiconductor
Procédé et circuit pilote destinés à la commande d'un semi-conducteur

(30) Priorität: 10.04.2008 DE 102008013275
(43) Veröffentlichungstag der Anmeldung: 14.10.2009
(73) Patentinhaber: SEMIKRON Elektronik GmbH & Co. KG, 90431 Nürnberg (DE)
(72) Erfinder: Jair, Do Nascimento, 91077 Dormitz (DE); Bode, Rüdiger, 90763 Fürth (DE); Mühlhofer, Alexander, 90522 Oberasbach (DE); Hofmeier, Markus, 91154 Roth (DE); Königsmann, Gunter, 91058 Erlangen (DE)

(56) Entgegenhaltungen:
- WO-A-99/44109
- DE-A1- 4 142 338
- US-A- 4 266 150
- US-A- 4 748 640

## Beschreibung

Die Erfindung betrifft ein Verfahren und eine Treiberschaltung zur Ansteuerung eines Leistungshalbleiters.

Leistungshalbleiter, wie z.B. IGBTs, Thyristoren oder MOSFETs werden in der Regel von einer Logikschaltung gesteuert, also z.B. ein- oder ausgeschaltet. Die Logikschaltung stellt hierbei lediglich das logische Schaltsignal, jedoch nicht die erforderliche Schaltleistung zur Verfügung. Diesen Zweck erfüllt ein zwischen Logikschaltung und Leistungshalbleiter befindlicher Treiber, welcher das leistungsschwache Logiksignal in ein leistungsstarkes Schaltsignal verstärkt.

Bekannte Treiber enthalten als einstufige Ansteuerung eine von der Logikschaltung ein- oder ausgeschaltete Spannungsquelle, die über einen Gatewiderstand an den Schalteingang (i.d.R. Gate) des Leistungshalbleiters angeschlossen ist. Der Wert des Gatewiderstandes muss hierbei geeignet gewählt werden, um das Schaltverhalten des Leistungshalbleiters in dessen Umschaltintervall, d.h. im Bereich des Miller-Plateaus, optimal zu bestimmen. Davor und danach, also außerhalb dieses Zeitbereiches, bewirkt der fest gewählte Gatewiderstand jedoch, dass sich die Spannung am Gate des Leistungshalbleiters nur langsam ändert. Dies und andere - hier nicht näher diskutierte - Effekte führen zu insgesamt langen Schaltzeiten und damit einer Grenze für die minimale Pulsweite bzw. Impulsdauer bei der Ansteuerung des Leistungshalbleiters, also für das spannungsgesteuerte Leistungsteil bzw. den Treiber.

Aus der US 4,266,150 ist es bekannt den Spannungsverlauf am Eingang eines elektro-mechanischen Schalters mittels eines als Zähler konfigurierten Frequenzteilers und eines nachgeschalteten Digital-Analog-Wandlers auszubilden. Hierbei wird durch erhöhen des Zählerwertes ein der Spannungswert um einen definierten Schritt vergrößert und durch erniedrigen des Zählerwertes entsprechend verringert. Hierdurch ergibt sich ein an- und absteigendes Treppensignal am Eingang des Digital-Analog-Wandlers. Um dem Treppensignal eine andere Form zu geben, wird lehrt, die Binärsignale aus dem Frequenzteiler mittels eines Festwert-Speicher-Matrix umzukodieren und dem Digital-Analog-Wandler zuzuführen.

Aufgabe der Erfindung ist es, ein verbessertes Verfahren und eine verbesserte Treiberschaltung zur Ansteuerung eines Leistungshalbleiters anzugeben.

Die Erfindung sieht ein Verfahren zur Ansteuerung eines Leistungshalbleiters gemäß Anspruch 1 sowie eine Treiberschaltung zur Ansteuerung eines Leistungshalbleiters gemäß Anspruch 5 vor. Bevorzugte Ausführungsformen der Erfindung sind in den Unteransprüchen beschrieben.

Die beanspruchte Erfindung lässt sich durch die in dieser Schrift, d.h. in der vorliegenden Beschreibung sowie in den Zeichnungen, beschriebenen und dargestellten Ausführungsbeispiele besser verstehen. Im Allgemeinen spiegelt die vorliegende Offenbarung bevorzugte Ausführungsbeispiele der Erfindung. Dem aufmerksamen Leser wird jedoch auffallen, dass einige Aspekte der beschriebenen Ausführungsbeispiele über den Schutzumfang der Ansprüche hinausragen. Sofern die beschriebenen Ausführungsbeispiele tatsächlich über den Schutzumfang der Ansprüche hinausragen, sind die beschriebenen Ausführungsbeispiele als zusätzliches Hintergrundinformation zu betrachten und stellen keine Definition der Erfindung per se dar.

Hinsichtlich des Verfahrens wird die Aufgabe gelöst durch ein Verfahren zur Ansteuerung eines Leistungshalbleiters mit folgenden Schritten: Zunächst wird auf das Eintreffen eines Ein- bzw. Ausschaltbefehls für den Leistungshalbleiter gewartet, welcher z.B. von der oben genannten Steuerlogik erzeugt wird. Ein Zähler - in der Regel für positive ganze Zahlen - ruht bis zu diesem Zeitpunkt und beinhaltet bzw. erzeugt eine Zahl eines unteren bzw. oberen Startwertes. Bei Absetzen des Schaltbefehls beginnt der Zähler auf- (z.B. zum Einschalten des Halbleiters) bzw. abwärts (zum Ausschalten) zu zählen. Beim Zählen erhöht oder erniedrigt der Zähler die Zahl in Zählschritten, z.B. in Einser-Schritten.

Der Zähler gibt die Zahl stets, also auch für jeden Zählschritt, an einen Speicher weiter. Der Speicher benutzt die Zahl als Adresse für seine Speicherinhalte. Im Speicher ist jeder Adresse ein Speicherwert zugeordnet. Der Speicher gibt damit für jeden Zählschritt einen Speicherwert, der der jeweiligen Adresse bzw. Zahl des Zählers entspricht, aus. Der Speicherwert wird als Eingangswert an einen Digital-Analog-Wandler übertragen. Der Digital-Analog-Wandler gibt daraufhin sein mit dem digitalen Eingangswert, also dem aktuellen Speicherwert korreliertes analoges Ausgangssignal, z.B. eine Spannung, aus und führt dieses dem Leistungshalbleiter zu.

Diese Prozedur wird so lange ausgeführt, bis der Zähler mit seiner Zahl einen oberen bzw. unteren Endwert erreicht. Der Zähler beendet das Zählen und gibt, wie vor Beginn des Zählens, konstant den oberen bzw. unteren Endwert als Zahl an den Speicher aus, weshalb der Digital-Analog-Wandler wieder entsprechend ein konstantes Ausgangssignal ausgibt.

Das erfindungsgemäße Verfahren wird in der Regel in einer entsprechenden Treiberschaltung realisiert. Die Erfindung beruht damit auf der Idee, digitale Intelligenz in eine Treiberschaltung bzw. die Ansteuerung eines Leistungshalbleiters einzubringen. Über entsprechend kombinierte Anzahlen von Zählschritten zwischen Start- und Endwerten und geeigneten Speicherwerten im Speicher ist somit durch das erfindungsgemäße Verfahren ein programmierbarer Gate-Spannungs-Verlauf in einem spannungsgesteuerten Leistungsteil bzw. einer Treiberschaltung realisiert. Durch Änderung von Start - und Endwerten, also Zählschritten kann bei konstantem Zähltakt die Zähldauer bzw. Schaltdauer des Treibers verändert werden. Durch Änderung von Speicherwerten ist ein beliebiger analoger Spannungsverlauf am Ausgang des Digital-Analog-Wandlers realisierbar. So kann eine einfache Anpassung der Treiberschaltung an beliebige Leistungshalbleiter erfolgen. Eine Anpassung zwischen Treiber und Leistungshalbleiter erfolgt somit auch nicht mehr zwingenderweise über den Gatewiderstand, sondern kann über den programmierbaren Spannungsverlauf erreicht werden.

Sämtliche bisherigen Ausführungen bezogen sich auf eine Spannungssteuerung des Leistungshalbleiters, können jedoch entsprechend auch auf eine Stromsteuerung übertragen werden.

Im Speicher ist als Zuordnung zwischen Adresse und Speicher mit anderen Worten ein Programm des Spannungsverlaufes über der Zeit abgelegt. Mit dem Verfahren ist jedoch weiterhin eine einstufige Ansteuerung des Halbleiters möglich, d.h. dass eine Spannungsquelle über einen Gatewiderstand an den Leistungshalbleiter angeschlossen ist. Der Gatewiderstand kann hierbei sehr klein gewählt werden, da dieser nur für die Strombegrenzung während des Umschaltintervalls nötig ist, um ein korrektes Schaltverhalten des Leistungshalbleiters sicher zu stellen. Vor und nach dem Umschaltintervall kann also erfindungsgemäß eine sogenannte schnelle Spannungskurve im Speicher programmiert werden. Durch das erfindungsgemäße Verfahren werden die Zeiten für die Abschnitte vor und nach dem Umschaltabschnitt verkürzt, weshalb sich die gesamte Schaltdauer des Leistungshalbleiters verkürzt. Die minimale Pulsweite zur Ansteuerung des Leistungshalbleiters wird dadurch gesenkt.

Für parallel verschaltete Halbleiter bzw. Treiber resultiert ein weiterer Vorteil: da der Gatewiderstand gegenüber bekannten Schaltungen kleiner ausgeführt werden kann, führen Spannungspulse auf dem Gate außerhalb der Umschaltzeiten zu kleineren, am Gatewiderstand abfallenden Spannungen. Störende Spannungspulse am Gate sind dadurch also kleiner, was die dU/dt-Störsicherheit bzw. Empfindlichkeit des Leistungshalbleiters verbessert.

Beim erfindungsgemäßen Verfahren können verschiedene Ein- bzw. Ausschaltbefehle abgesetzt werden. So können z.B. neben Standard-Ein- und Ausschaltbefehlen auch Kurzschluss-Ausbefehle oder verschiedene Einschaltbefehle mit verschiedenen Schaltzeiten abgesetzt werden. In einer vorteilhaften Ausführungsform kann dann für verschiedene Ein- bzw. Ausschaltbefehle der Zähler zwischen verschiedenen Start- und/oder Endwerten zählen. Somit sind für verschiedene Schaltbefehle verschieden viele Zählschritte, Anfangs- oder Endwerte realisierbar, was zu jeweils verschiedenen Ein- und Ausschaltzeiten beim Leistungshalbleiter führt. Z.B. kann bei einem Kurzschluss eine kürzere Ausschaltzeit erreicht werden. Der Stromanstieg während der Abschaltung des Leistungshalbleiters wird dadurch minimiert, Überspannungen durch parasitäre Induktivitäten werden dadurch reduziert und somit der Kurzschlussschutz insgesamt verbessert.

In einer weiteren bevorzugten Ausführungsform können für verschiedene Ein- bzw. Ausschaltbefehle im Speicher verschiedene Zuordnungen von Speicherwerten zu Adressen verwendet werden. Je nach Ein- oder Ausschaltbefehl sind somit andere Spannungsverläufe im Speicher ablegbar, d.h. programmierbar und stehen im Betrieb für den Leistungshalbleiter zur Verfügung.

Wie bereits erwähnt, kann der Gatewiderstand gegenüber bekannten Schaltungen deutlich reduziert werden. Ein diskret aufgebauter Gatewiderstand kann entweder in der Treiberschaltung oder im Leistungshalbleitermodul vorgesehen sein. Im Grenzfall kann der Gatewiderstand sogar weggelassen werden, wenn z.B. der parasitäre Gatewiderstand des Leistungshalbleiters oder des Treibers alleine bereits ausreicht. In einer bevorzugten Ausführungsform der Erfindung wird daher das Ausgangssignal dem Leistungshalbleiter ohne Zwischenschaltung eines Widerstands zugeführt.

Bei dem erfindungsgemäßen Verfahren ist es wichtig, während eines Schaltvorgangs im Leistungshalbleiter die jeweiligen Zeit- bzw. Spannungs- oder Strompunkte zu definieren, bei welchen das eigentliche Umschaltintervall im Leistungshalbleiter beginnt und endet. Für viele Leistungshalbleiter ist jedoch der Schalteingang, also das Gate, nicht direkt für eine Spannungsmessung zugänglich bzw. diese generell unerwünscht. Da jedoch die Eingangskapazität zwischen Gate und Emitter in der Regel gut bekannt ist, ist auch die Zeitkonstante bekannt. Diese Charakteristik kann dann zur Bestimmung der jeweiligen Start- und Endpunkte der Umschaltintervalle beim Ein- und Ausschaltvorgang verwendet werden. Zumindest für den Endzeitpunkt des Kommutationszeitintervalls kann in einer vorteilhaften Ausführungsform des Verfahrens eine Überwachungseinheit das Schaltverhalten des Leistungshalbleiters ausgangsseitig überwachen. Hier kann z.B. die Sättigungsspannung im dynamischen Bereich zwischen Kollektor und Emitter beobachtet werden, welche eine Aussage über das Erreichen des entsprechenden Intervallendes erlaubt. Im Verfahren können dann Speicherwerte und/oder Startwerte und/oder Endwerte in Abhängigkeit des Schaltverhaltens des Leistungshalbleiters verändert werden. So ist eine dynamische Reglung möglich, welche den Treiber stets an entsprechende mit dem Verfahren angesteuerte Leistungshalbleiter adaptiert.

Auf Grund der Mehrkosten für eine derartige Überwachungseinheit wird jedoch in der Regel für das Umschaltintervall ein konstantes Zeitintervall für eine bestimmte Anwendungen, d.h. einen vom Verfahren anzusteuernden Typ Leistungshalbleiter fest gewählt.

In der Regel wird natürlich das vom Digital-Analog-Wandler ausgegebene Spannungssignal nochmals durch einen Verstärker verstärkt, bevor es dem Leistungshalbleiter zugeführt wird.

Hinsichtlich der Treiberschaltung wird die gestellte Aufgabe gelöst durch eine Treiberschaltung zur Ansteuerung eines Leistungshalbleiters. Die Treiberschaltung weist einen Signaleingang zum Empfangen eines Ein- bzw. Ausschaltbefehls für den Leistungshalbleiter auf. Die Treiberschaltung enthält außerdem einen vom Signaleingang startbaren Zähler für eine auf- und abwärts zählbare Zahl und einen mit dem Zähler verbundenen Speicher. Der Speicher weist mehrere, jeweils einer Adresse zugeordnete Speicherwerte auf. Die Zahl des Zählers ist hierbei die Adresse des Speichers. Der Speicher ist mit einem Digital-Analog-Wandler verbunden. Der Eingangswert des Digital-Analog-Wandlers ist der Speicherwert des Speichers. Der Analogwandler dient zur Wandlung des digitalen Eingangswertes in ein analoges, mit diesem korreliertes Ausgangssignal. Das Ausgangssignal ist zu einem Steuerausgang geführt. Am Steuerausgang ist der Leistungshalbleiterschalter anschließbar.

Die erfindungsgemäße Treiberschaltung wurde zusammen mit ihren Vorteilen bereits im Zusammenhang mit dem erfindungsgemäßen Verfahren erläutert.

In einer vorteilhaften Ausführungsform kann die Treiberschal-, tung mehrere Signaleingänge enthalten. Hierfür ist sie zur Ausführung der Verfahrensvariante geeignet, bei welcher verschiedene Ein- und Ausschaltbefehle für den Leistungshalbleiter an den verschiedenen Signaleingängen anlegbar sind.

In einer weiteren vorteilhaften Ausführungsform weist die Treiberschaltung mehrere Zähler auf, welche jeweils mit den Signaleingängen verbunden sind. Hierdurch können, wie oben erwähnt, verschiedene Ein- bzw. Ausschaltbefehle die veschiedenen Zähler zur Zählen zwischen verschiedenen Start- und/oder Endwerten veranlassen.

In einer anderen vorteilhaften Ausführungsform weist die Treiberschaltung mehrere Speicher mit verschiedenen Paaren von Adressen und Speicherwerten auf. Die verschiedenen Speicher können hierbei - wie auch die o.g. Zähler - tatsächlich physikalisch verschiedene Bauelemente sein oder auch in bekannter Weise als Logikschaltung in einem integrierten Baustein, z.B. in einem FPGA oder ASIC, ausgeführt sein. Dann handelt es sich nicht um Speicherzellen im herkömmlichen Sinn, sondern z.B. um eine mittels VHDL-Code beschriebene Teilschaltungsanordnung innerhalb des integrierten Bausteins. Eine derartige Treiberschaltung kann die oben erwähnten verschiedenen Zuordnungen von Speicherwerten zu Adressen realisieren, indem zwischen verschiedenen Speichern umgeschaltet wird. Hier bei ist alternativ auch der Austausch der Speicherinhalte möglich.

Die Treiberschaltung kann in einer weiteren vorteilhaften Ausführungsform eine Überwachungseinheit aufweisen, die ausgangsseitig an den Leistungshalbleiterschalter anschließbar ist und auf den Speicher und/oder den Zähler einwirkt. So ist die oben erwähnte Anpassung des Schaltverhaltens der Treiberschaltung an das reale Schaltverhalten eines angeschlossenen Leistungshalbleiterschalters durch die genannten Anpassungen ausführbar.

Für eine weitere Beschreibung der Erfindung wird auf die Ausführungsbeispiele der Zeichnungen verwiesen. Es zeigen, jeweils in einer schematischen Prinzipskizze:
- Fig. 1: eine erfindungsgemäße Treiberschaltung mit angeschlossenem Leistungshalbleiter,
- Fig. 2: verschiedene elektrische Signale beim Betrieb der Treiberschaltung aus Fig. 1 im zeitlichen Verlauf,
- Fig. 3: den Inhalt des Speichers aus Fig. 1,
- Fig. 4: eine alternative Ausführungsform der Treiberschaltung aus Fig. 1 mit zusätzlichen Signaleingängen, Zählern und Speichern,
- Fig. 5: verschiedene elektrische Signale beim Betrieb der Treiberschaltung aus Fig. 4 im zeitlichen Verlauf,.

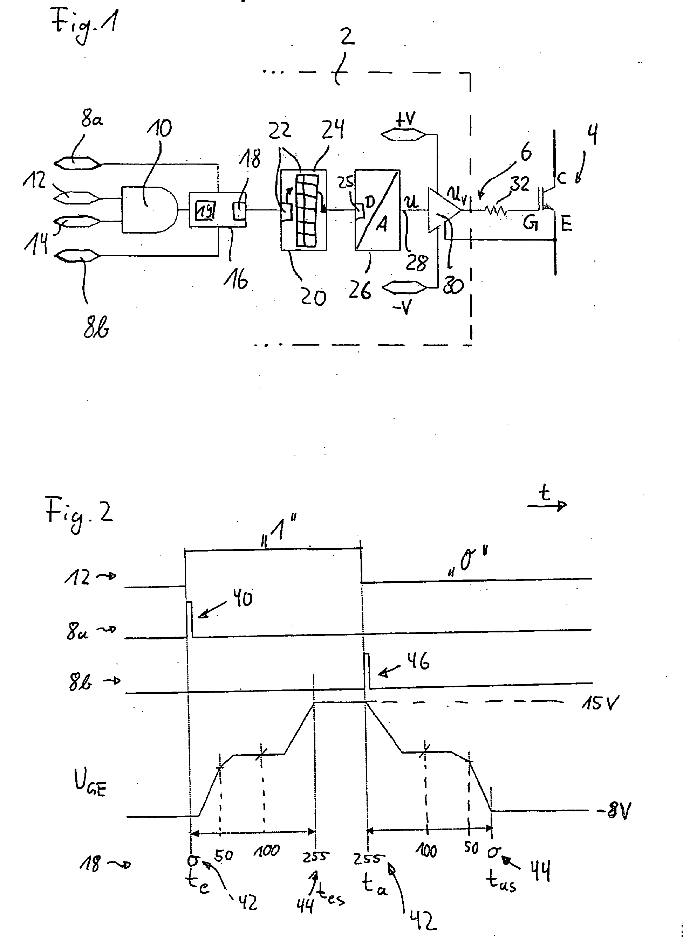

Fig. 1 zeigt als Treiberschaltung einen Treiber 2 an dessen Ausgang 6 als Leistungshalbleiter ein IGBT 4 mit seinem Gate G angeschlossen ist. Der Treiber 2 weist als Signaleingänge zwei Eingänge 8a zum Einschalten des IGBT 4 und 8b zu dessen Ausschalten auf. Der Treiber 2 enthält außerdem einen PWM-Eingang 12 und einen Takteingang 14, die auf eine Logik 10 geführt sind.

Der Ausgang des Logik 10 sowie die Eingänge 8a,b sind als Eingänge auf einen Zähler 16 geführt. Der Zähler 16 ist in der Regel ein digitaler Standard-Zähler, der mit positiven ganzen Zahlen arbeitet und an seinem Ausgang z.B. bei 8bit Zählbreite Zahlen zwischen 0 und 255 erzeugt. Der Zähler 16 zählt bei aktivem Eingang 8a und aktivem PWM-Eingang 12 gemäß dem Takt des Takteingangs 14 eine interne Zahl 18 in Zählschritten 19 hoch bzw. bei Aktivität des Eingangs 8b herunter.

Am die Zahl 18 liefernden Ausgang des Zählers 16 ist ein Speicher 20 mit seinem Eingang angeschlossen, wobei die Zahl 18 diesem als Adresse 22 dient. Jeder möglichen Adresse 22 ist im Speicher 20 ein Speicherwert 24 zugewiesen, der bei entsprechendem Anliegen der Adresse 22 vom Speicherbaustein 20 ausgegeben und an einen an diesem angeschlossenen D/A-Wandler 26 weitergegeben wird.

Der D/A-Wandler 26 erzeugt an seinem Ausgang 28 eine dem Wert 24, also seinem digitalen Eingangswert 25 entsprechende analoge Spannung U, welche einem Verstärker 30 zugeführt wird. Der Verstärker 30 verstärkt die Spannung U auf einen entsprechenden Verstärkungsbereich zwischen den Versorgungsspannungen +V und -V, um die entsprechend verstärkte Spannung Uᵥ als Ansteuersignal für den IGBT 4 am Ausgang 6 auszugeben.

In einer alternativen Ausführungsform ist zwischen Ausgang 6 und Gate G ein optionaler Gatewiderstand 32 geschaltet, welcher eine Strombegrenzung des IGBT 4 beim Schaltvorgang am Miller-Plateau bzw. bei der eigentlichen Kommutierung bewirkt.

Fig. 2 zeigt über der Zeit t den Verlauf der Signale am PWM-Eingang 12, an den Eingängen 8a und 8b und der Spannung U_{GE} zwischen Gate G und Emitter E des IGBT 4. Zum Einschaltzeitpunkt tₑ empfängt der Treiber 4 am Eingang 8a einen Einschaltpuls 40, mit dem gleichzeitig der PWM-Eingang 12 auf logische "1" gezogen wird, d.h. der IGBT 4 soll einschalten. Die Logik 10 erzeugt hier in nicht näher erläuterter Weise Steuersignale für den Betrieb des Zählers 16. Da der Zähler 16 über dem mit dem Einschaltpuls 40 aktivierten Eingang 8a auf Aufwärtszählen geschaltet ist, erhöht dieser die Zahl 18 ausgehend vom Startwert 42 mit Wert "0" in Zählschritten 19 des Wertes "1" bis zum Endwert 44 mit Wert "255".

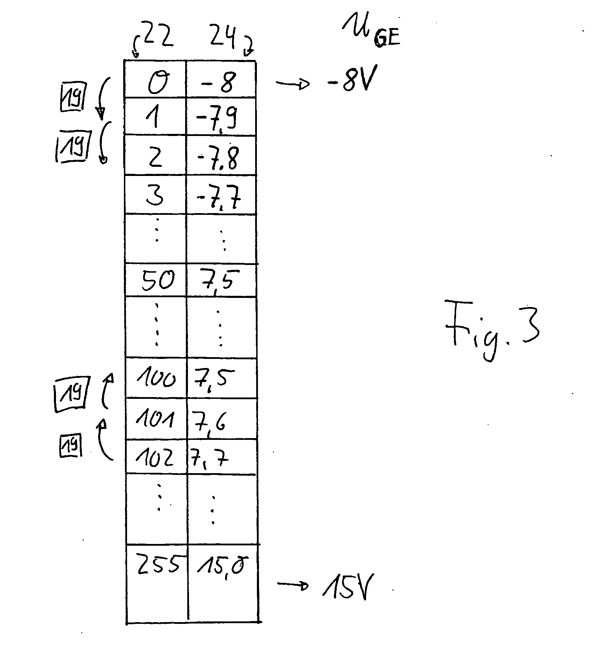

Fig. 3 zeigt, wie die vom Zähler erzeugten Zahlen 18 als Adressen 22 im Speicher 20 Werten 24 zugeordnet sind bzw. werden. Beginnend ab dem Einschaltzeitpunkt tₑ durchläuft also die Zahl 18 in Form der Adresse 22 die Zahlen von "0" bis "255". Der Speicher 20 liefert daher fortlaufend als Werte 24 die in Fig. 3 gezeigten Zahlen zwischen "-8" und "15,0" als Digitalwerte. Diese werden vom D/A-Wandler 26 in die tatsächlichen Spannungen U von -8V bis 15V umgesetzt. Beim Erreichen des Endwertes 44 "255"zum Zeitpunkt tₑₛ hört der Zähler 16 auf, die Zahl 18 zu erhöhen, da diese den Wert "255" erreicht hat. Es wird weiterhin als Zahl 18 der Wert "255" ausgegeben, weshalb bis zum Zeitpunkt tₐ die Spannung U_{GE} 15V beträgt.

Zwischen den Zahlen 18 mit Werten "50" bis "100" wird die vom DA-Wandler 26 erzeugte Spannung auf 7,5V gehalten. Die Gate-Emitterspannung U_{GE} dagegen ändert sich leicht, da hier das Umschalten des IGBT 4 einsetzt.

Zum Zeitpunkt tₐ wird am Eingang 8b ein Ausschaltsignal für den IGBT 4 als Ausschaltpuls 46 erzeugt. Hierdurch wird der Zähler 16 auf Abwärtszählen geschaltet und zählt die Zahl 18 vom Wert "255", der nun als Startwert 42 dient, bis zum Endwert 44 von "0" herab. Gemäß Fig. 3 werden so die Speicherwerte 24 vom Wert "15,0" bis zum Wert "-8" zurückgezählt, weshalb die Gate-Emitterspannung U_{GE} entsprechend dem programmierten Verlauf abfällt. Auch hier gilt das oben gesagte für die Kommutation des IGBT 4.

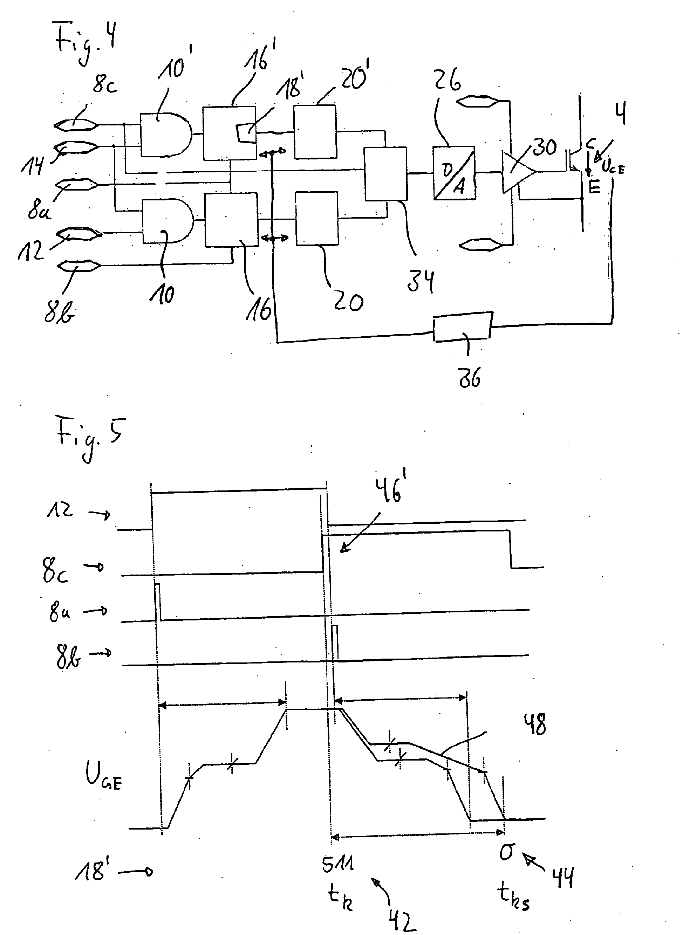

Die Schaltung in Fig. 4 ist gegenüber der in Fig. 1 um einen zusätzlichen Eingang 8c erweitert, welcher für einen Ausschaltvorgang des IGBT 4 im Kurzschlussfall angesteuert wird. Der Schalteingang 8c ist um ein zusätzliches Logik 10' mit einem speziellen Zähler 16' als Kurzschlussabwärtszähler verbunden, welcher seinerseits mit einem speziellen Speicher 20' als Abwärtszählspeicher kombiniert ist. der Zähler 16' verfügt über 9 Bit, also insgesamt 512 Zählschritte für dessen Zahl 18'. Auch der Speicher 20' verfügt über 512 Adressen, welche entsprechend Fig. 3 jeweiligen Werten 24' zugeordnet sind, die beim Zählen des Zählers 16' nacheinander dem D/A-Wandler 26 zugeführt werden. Zum Umschalten zwischen den Speichern 20 und 20' ist in den Signalpfad noch ein Multiplexer 34 geschaltet.

Fig. 5 zeigt neben dem bekannten Ein- und Ausschaltvorgang aus Fig. 2 außerdem einen Kurzschlussausschaltvorgang, wenn nämlich der Eingang 8c zum Zeitpunkt tₖ aktiviert wird. Dann zählt der Zähler 16' die Zahl 18' vom Wert "511" zurück bis zum Wert "0". Durch gegenüber Fig. 3 geänderte Werte 24' im Speicher 20' wird die Schaltcharakteristik 48 für die Gate-Emitterspannung U_{GE} erreicht.

In Fig. 4 ist zusätzlich eine Ausführungsform des Treibers 4 gezeigt, die zusätzlich eine Überwachungseinheit 36 enthält. Diese überwacht die Spannung U_{CE} zwischen Kollektor C und Emitter E des IGBT 4. In Abhängigkeit des Zeitverlaufs der Spannung U_{CE} verändert die Überwachungseinheit 36 während der in Fig. 2 und Fig. 5 gezeigten Schaltvorgänge die Startwerte 42, Endwerte 44 und Speicherinhalte, also Werte 24,24' in den Speichern 20,20'. So wird die Ansteuerung des IGBT 4 speziell an dessen tatsächliches Schaltverhalten angepasst.

## Patentansprüche

1. Verfahren zur Ansteuerung eines Leistungshalbleiters (4), bei dem bei Absetzen eines über mehrere signaleingänge zu empfanfenen Ein- (40) bzw. Ausschaltbefehls (46,46') für den Leistungshalbleiter (4):
ein, eine Zahl (18,18') eines unteren bzw. oberen Startwertes (42) aufweisender Zähler (16,16') beginnt, die Zahl (18,18') in Zählschritten (19) zu erhöhen bzw. zu erniedrigen, wobei
für jeden Zählschritt (19) die Zahl (18,18') als Adresse (22) an einen Speicher (20,20') übermittelt wird,
der Speicher (20,20') für jede Adresse (22) einen dieser zugeordneten Speicherwert (24) als Eingangswert (25) an einen Digital-Analog-Wandler (26) ausgibt, dessen mit dem Eingangswert (25) korreliertes Ausgangssignal (U) dem Leistungshalbleiter (4) zugeführt wird,
verschiedene Ein- (40) bzw. Ausschaltbefehle (46,46') abgesetzt werden, bei dem der Zähler (16,16') für verschiedene Ein- (40) bzw. Ausschaltbefehle (46,46') zwischen verschiedenen Start- (42) und/oder Endwerten (44) zählt, und
der Zähler (16,16') anhält, wenn die Zahl (18,18') einen oberen bzw. unteren Endwert (44) erreicht.

2. Verfahren nach Anspruch 1, wobei verschiedene Ein- (40) bzw. Ausschaltbefehle (46,46') abgesetzt werden, bei dem im Speicher (20,20') für verschiedene Ein- (40) bzw. Ausschaltbefehle (46,46') verschiedene Zuordnungen von Speicherwerten (24) zu Adressen (22) verwendet werden.

3. Verfahren nach einem der vorhergehenden Ansprüche, bei dem das Ausgangssignal (Uᵥ) dem Leistungshalbleiter (4) ohne Zwischenschaltung eines Widerstands zugeführt wird.

4. Verfahren nach einem der vorhergehenden Ansprüche, bei dem eine Überwachungseinheit (36) das Schaltverhalten des Leistungshalbleiters (4) ausgangsseitig überwacht und die Speicherwerte (24) und/oder die Startwerte (42) und/oder die Endwerte (44) in Abhängigkeit des Schaltverhaltens verändert werden.

5. Treiberschaltung (2) zur Ansteuerung eines Leistungshalbleiters (4), mit
mehreren Signaleingängen (8a-c) zum Empfang verschiedener Ein- (40) bzw. Ausschaltbefehle (46,46') für den Leistungshalbleiter (4),
einem von den verschiedenen Signaleingängen (8a-c) startbaren Zähler (16,16') für eine auf- und abwärts zählbare Zahl (18,18') zwischen verschiedenen Start- (42) und/oder Endwerten (44),
einem mit dem Zähler (16,16') verbundenen Speicher (20,20') mit mehreren, einer jeweiligen Adresse (22) zugeordneten Speicherwerten (24,24'), wobei die Zahl (18,18') die Adresse (22) des Speichers (20,20') ist, und
einem mit dem Speicher (20,20') verbundenen Digital-Analog-Wandler (26), dessen Eingangswert (25) der Speicherwert (24) ist, wobei das mit dem Eingangswert (25) korrelierte Ausgangssignal (U) des Digital-Analog-Wandlers (26) zu einem Steuerausgang (6) für den Leistungshalbleiterschalter (4) geführt ist, wobei
der Zähler (16,16') anhält, wenn die Zahl (18,18') einen oberen bzw. unteren Endwert (44) erreicht.

6. Treiberschaltung (2) nach Anspruch 5, die mehrere, mit den Signaleingängen (8a-c) erbundene Zähler (16,16') enthält.

7. Treiberschaltung (2) nach Anspruch 5 oder 6, die mehrere Speicher (20,20') mit verschiedenen Paaren von Adressen (22) und Speicherwerten (24,24') enthält.

8. Treiberschaltung (2) nach einem der Ansprüche 5 bis 7, bei der der Zähler (16,16') und/oder der Speicher (20,20') als Logikschaltung in einem integrierten Baustein ausgeführt ist.

9. Treiberschaltung (2) nach einem der Ansprüche 5 bis 8, mit einer an den Leistungshalbleiterschalter (4) ausgangsseitig anschließbaren, auf den Speicher (20,20') und/oder den Zähler (16,16') einwirkenden Überwachungseinheit (36).

## Claims

1. Method for the activation of a power semiconductor (4), in which, upon issue of a switch-on (40) or switch-off (46, 46') command to be received via several signal inputs for the power semiconductor (4), a counter (16, 16') which has a number (18, 18') of a lower or upper starting value (42) begins to increase or decrease the number (18, 18') in counting steps (19), wherein
for each counting step (19) the number (18, 18') is transmitted as an address (22) to a memory (20, 20'),
the memory (20, 20') issues for each address (22) a memory value (24) assigned to the latter as an input value (25) to a digital-to-analogue converter (26), of which the output signal (U) which is correlated with the input value (25) is delivered to the power semiconductor (4),
different switch-on (40) or switch-off (46, 46') commands are issued, in which the counter (16, 16') for different switch-on (40) or switch-off (46, 46') commands counts between different starting values (42) and/or final values (44), and
the counter (16, 16') stops when the number (18, 18') reaches an upper or lower final value (44).

2. Method according to claim 1, wherein different switch-on (40) or switch-off (46, 46') commands are issued, in which in the memory (20, 20') for different switch-on (40) or switch-off (46, 46') commands different correlations of memory values (24) with addresses (22) are used.

3. Method according to any of the preceding claims, in which the output signal (Uᵥ) is delivered to the power semiconductor (4) without the interposition of a resistance.

4. Method according to any of the preceding claims, in which a monitoring unit (36) monitors the switching behaviour of the power conductor (4) on the output side, and the memory values (24) and/or the starting values (42) and/or the final values (44) are varied as a function of the switching behaviour.

5. Driver circuit (2) for the activation of a power semiconductor (4), having
several signal inputs (8a-c) for the reception of different switch-on (40) or switch-off (46, 46') commands for the power semiconductor (4),
a counter (16, 16') which can be started by the different signal inputs (8a-c) for a number (18, 18') which can be counted up or down between different starting values (42) and/or final values (44),
a memory (20, 20') connected to the counter (16, 16') and having several memory values (24, 24') each assigned to an address (22), wherein the number (18, 18') is the address (22) of the memory (20, 20'), and
a digital-to-analogue converter (26) which is connected to the memory (20, 20') and of which the input value (25) is the memory value (24), wherein the output signal (U) of the digital-to-analogue converter (26) which is correlated with the input value (25) is passed to a control output (6) for the power semiconductor (4), wherein
the counter (16, 16') stops when the number (18, 18') reaches an upper or lower final value (44).

6. Driver circuit (2) according to claim 5, which contains several counters (16, 16') connected to the signal inputs (8a-c).

7. Driver circuit (2) according to claim 5 or 6, which contains several memories (20, 20') with different pairs of addresses (22) and memory values (24, 24').

8. Driver circuit (2) according to any of claims 5 to 7, in which the counter (16, 16') and/or the memory (20, 20') is designed as a logic circuit in an integrated chip.

9. Driver circuit (2) according to any of claims 5 to 8, having a monitoring unit (36) which can be connected on the output side to the power semiconductor switch (4) and which acts on the memory (20, 20') and/or the counter (16, 16').

## Revendications

1. Procédé de commande d'un semi-conducteur de puissance (4), dans lequel, par initiation d'une instruction, à recevoir sur plusieurs entrées de signaux, d'activation (40) ou de désactivation (46, 46') pour le semi-conducteur de puissance (4) :
un compteur (16, 16') présentant un nombre (18, 18') d'une valeur initiale (42) inférieure ou supérieure commence à augmenter ou à diminuer le nombre (18, 18') par pas de comptage (19),
le nombre (18, 18') est transmis en tant qu'adresse (22) à une mémoire (20, 20') pour chaque pas de comptage (19),
la mémoire (20, 20') délivre pour chaque adresse (22) une valeur de mémoire (24) associée à celle-ci en tant que valeur d'entrée (25) à un convertisseur numérique-analogique (26), dont le signal de sortie (U) corrélé à la valeur d'entrée (25) est transmis au semi-conducteur de puissance (4),
différentes instructions d'activation (40) ou de désactivation (46, 46') sont initiées, le compteur (16, 16') comptant entre différentes valeurs initiales (42) et/ou valeurs finales (44) pour différentes instructions d'activation (40) ou de désactivation (46, 46'), et
le compteur (16, 16') s'arrête quand le nombre (18, 18') atteint une valeur finale (44) supérieure ou inférieure.

2. Procédé selon la revendication 1, dans lequel différentes instructions d'activation (40) ou de désactivation (46, 46') sont initiées, différentes associations de valeurs de mémoire (24) à des adresses (22) étant utilisées dans la mémoire (20, 20') pour différentes instructions d'activation (40) ou de désactivation (46, 46').

3. Procédé selon l'une des revendications précédentes, dans lequel le signal de sortie (Uᵥ) est transmis au semi-conducteur de puissance (4) sans intercalation d'une résistance.

4. Procédé selon l'une des revendications précédentes, dans lequel une unité de surveillance (36) surveille le comportement de commutation du semi-conducteur de puissance (4) côté sortie, et les valeurs de mémoire (24) et/ou les valeurs initiales (42) et/ou les valeurs finales (44) sont modifiées en fonction du comportement de commutation.

5. Circuit d'attaque (2) pour la commande d'un semi-conducteur de puissance (4), comportant :
plusieurs entrées de signal (8a-c) pour la réception de différentes instructions d'activation (40) ou de désactivation (46, 46') pour le semi-conducteur de puissance (4),
un compteur (16, 16') démarrable par les différentes entrées de signal (8a-c) pour un nombre (18, 18') à comptage ascendant et descendant entre différentes valeurs initiales (42) et/ou valeurs finales (44),
une mémoire (20, 20') reliée au compteur (16, 16') avec plusieurs valeurs de mémoire (24, 24') associées chacune à une adresse (22) correspondante, le nombre (18, 18') étant l'adresse (22) de la mémoire (20, 20'), et
un convertisseur numérique-analogique (26) relié à la mémoire (20, 20'), dont la valeur d'entrée (25) est la valeur de mémoire (24), le signal de sortie (U) du convertisseur numérique-analogique (26) corrélé à la valeur d'entrée (25) étant transmis à une sortie de commande (6) pour l'interrupteur à semi-conducteur de puissance (4),
le compteur (16, 16') s'arrêtant quand le nombre (18, 18') atteint une valeur finale (44) supérieure ou inférieure.

6. Circuit d'attaque (2) selon la revendication 5, comprenant plusieurs compteurs (16, 16') reliés aux entrées de signal (8a-c).

7. Circuit d'attaque (2) selon la revendication 5 ou 6, comprenant plusieurs mémoires (20, 20') reliées à différentes paires d'adresses (22) et valeurs de mémoire (24, 24').

8. Circuit d'attaque (2) selon l'une des revendications 5 à 7, dans lequel le compteur (16, 16') et/ou la mémoire (20, 20') sont réalisées comme circuit logique dans un module intégré.

9. Circuit d'attaque (2) selon l'une des revendications 5 à 8, comportant une unité de surveillance (36) raccordable à l'interrupteur à semi-conducteur de puissance (4) côté sortie, et agissant sur la mémoire (20, 20') et/ou le compteur (16, 16').
